# FASCICULE DE BREVET EUROPEEN

(11) **EP 0 863 589 B1**
(45) Date de publication et mention de la délivrance du brevet: **28.07.2004**
(21) Numéro de dépôt: 98400477.0
(22) Date de dépôt: 27.02.1998
(51) Int. Cl.: H01S 5/30

(54) **Laser unipolaire multi-longueurs d'ondes**
Unipolarer Multiwellenlängenlaser
Unipolar multiwavelength laser

(30) Priorité: 04.03.1997 FR 9702545
(43) Date de publication de la demande: 09.09.1998
(73) Titulaire: Thales, 75008 Paris (FR)
(72) Inventeur: Berger, Vincent, 94117 Arcueil Cedex (FR)

(56) Documents cités:
- EP-A- 0 676 839
- FAIST J ET AL: "HIGH POWER MID-INFRARED (LAMBDA 5 MUM) QUANTUM CASCADE LASERS OPERATING ABOVE ROOM TEMPERATURE" APPLIED PHYSICS LETTERS, vol. 68, no. 26, 24 juin 1996, pages 3680-3682, XP000599581
- SIRTORI C ET AL: "CONTINUOUS WAVE OPERATION OF MIDINFRARED (7.4-8.6 MUM) QUANTUM CASCADE LASERS UP TO 110 K TEMPERATURE" APPLIED PHYSICS LETTERS, vol. 68, no. 13, 25 mars 1996, pages 1745-1747, XP000582368
- FAIST J ET AL: "QUANTUM CASCADE LASER" SCIENCE, vol. 264, no. 5158, 22 avril 1994, pages 553-556, XP000541768
- PATENT ABSTRACTS OF JAPAN vol. 012, no. 500 (E-699), 27 décembre 1988 & JP 63 211786 A (CANON INC), 2 septembre 1988,
- PATENT ABSTRACTS OF JAPAN vol. 013, no. 543 (P-970), 6 décembre 1989 & JP 01 224642 A (CANON INC), 7 septembre 1989,

## Description

L'invention concerne un laser unipolaire multi-longueurs d'ondes à puits quantiques.

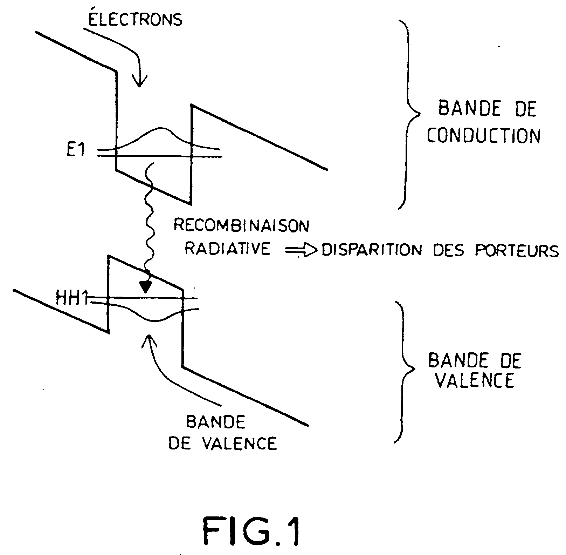

Dans un laser à semiconducteur traditionnel, l'émission de photons se produit lors d'une recombinaison entre un électron de la bande de conduction et un trou de la bande de valence. La figure 1 reprend schématiquement comme exemple le cas d'un laser à puits quantiques. Dans ce cas, la longueur d'onde d'émission est simplement fixée par l'énergie de la transition entre les deux niveaux fondamentaux E1 et HH1. Cette énergie peut être modifiée en changeant, par exemple, la largeur du puits quantiques. Cependant, si on place, dans la cavité d'un laser à semiconducteur, plusieurs puits quantiques émettant à des longueurs d'ondes différentes, le système global ne va pas émettre de radiation laser à toutes ces différentes longueurs d'onde simultanément. Il va en effet se produire un effet de compétition entre les différents puits ; un seul va l'emporter, et le dispositif présentera une émission à la seule longueur d'onde du « vainqueur ». Cela s'explique ainsi : si on augmente le courant d'injection, une fois passé le seuil laser pour un seul de ces puits, le dispositif est en fonctionnement laser, avec une émission stimulée qui vide extrêmement rapidement ce puits, et pompe en conséquence la totalité des porteurs (électrons et trous) qui sont injectés, puis perdus lors de la recombinaison radiative. Le niveau de Fermi est donc bloqué et n'augmente plus lorsqu'on augmente le courant. Les autres puits ne pourront donc pas augmenter leur densité de porteurs et n'atteindront pas leur seuil de fonctionnement laser. Ces effets sont très connus dans la littérature (voir document référencé [1] en fin de description).

Les lasers à cascade quantiques (LCQ) apparus en 1994 (voir documents [2] et [3] en fin de description) présentent une différence importante avec ces lasers classiques : l'émission d'un photon se fait à l'intérieur d'une seule bande, et n'implique qu'un seul type de porteurs. C'est pourquoi les LCQ peuvent être aussi appelés « lasers unipolaires ». En fonctionnant dans la bande de conduction, ce type de porteur est l'électron, mais on pourrait envisager des transitions à l'intérieur de la bande de valence. Un tel fonctionnement est appelé intra-bande. En fonctionnement dans la bande de conduction, l'émission implique seulement des électrons, il n'y a pas de disparition des porteurs lors de l'émission d'un photon, comme c'est le cas dans les lasers classiques. Le même électron peut d'ailleurs être utilisé plusieurs fois dans plusieurs puits quantiques en traversant la structure, et émettre ainsi plusieurs photons.

L'invention tire partie de cette propriété pour faire en sorte qu'un même électron soit utilisé plusieurs fois dans plusieurs puits quantiques.

L'invention concerne donc un laser unipolaire à puits quantiques multi-longueurs d'ondes comprenant au moins deux empilements de couches de matériaux semiconducteurs, chaque empilement constituant un laser à puits quantique fonctionnant par transition intra-bande et émettant une longueur d'onde déterminée, caractérisé en ce que les deux empilements de couches sont séparés par un empilement de couches de matériaux semiconducteurs constituant un réseau de transfert à puits quantiques permettant, sous champ électrique, un transfert d'électrons entre le niveau bas de la bande (de conduction ou de valence) d'un premier puits quantique vers le niveau haut de la bande (de conduction ou de valence) d'un deuxième puits quantique.

Les différents objets et caractéristiques de l'invention apparaîtront plus clairement dans la description qui va suivre et dans les figures annexées qui représentent :
- la figure 1, une représentation d'un laser à puits quantiques fonctionnant en transition inter-bandes ;
- les figures 2a et 2b, une représentation d'un laser à puits quantiques selon l'invention ;
- la figure 3, une représentation plus détaillée d'un laser à puits quantiques selon l'invention ;
- les figures 4a à 4d, des exemples de réalisation détaillés du dispositif de l'invention ;
- la figure 5, un système d'analyse appliquant le dispositif de l'invention.

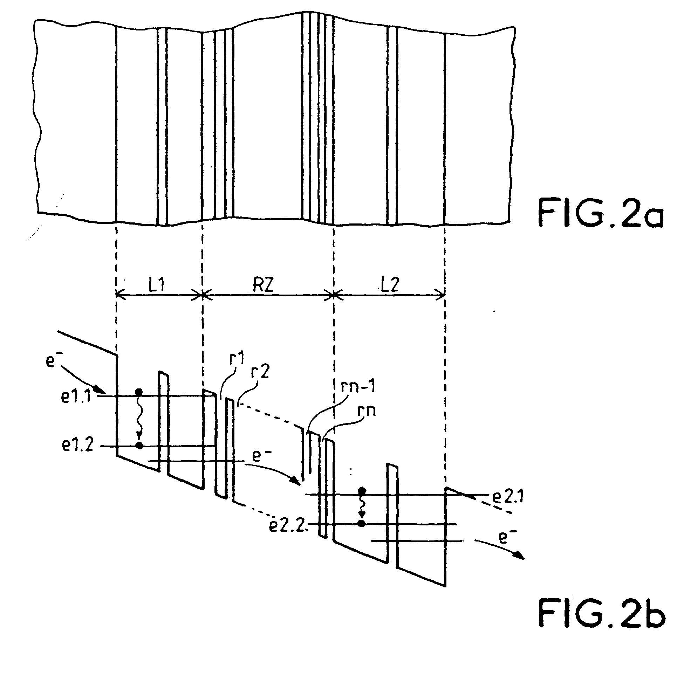

En se reportant aux figures 2a et 2b, on va donc tout d'abord décrire de façon générale l'objet de l'invention.

La figure 2a représente plusieurs empilements de couches constituant des puits quantiques :
- l'empilement de couches L1 constitue un premier laser à puits quantique émettant à une première longueur d'onde λ₁;
- l'empilement de couches L2 constitue un deuxième laser à puits quantique émettant à une deuxième longueur d'onde λ₂;
- l'empilement de couches RZ constitue un réseau de couplage à puits quantiques permettant de transférer les électrons du laser L1 vers le laser L2 comme cela va être décrit.

La figure 2b représente le profil de la bande de conduction de ces différents empilements de couches.

Chaque laser possède au moins deux niveaux d'énergie e1.1 et e1.2 pour le laser L1, et e2.1 et e2.2 pour le laser L2. Sous excitation électrique, le profil de bande de conduction est tel que le niveau e1.2 est à un niveau supérieur au e2.1. Le réseau de puits quantique RZ est conçu de façon à conduire les électrons du puits quantique du laser L1 vers le puits quantique du laser L2 en passant du niveau e1.2 au niveau e2.1.

Pour simplifier, nous n'avons considéré que deux niveaux d'énergie par puits quantiques Cependant, comme représenté figure 1, page 554 de la référence [3], un troisième niveau d'énergie peut être considéré.

Le réseau RZ est constitué d'une succession de puits quantiques qui contiennent des niveaux d'énergie sur lesquels s'organise le transport d'électrons entre le niveau d'énergie bas e1.2 du laser L1 et le niveau d'énergie haut e2.1 du laser L2.

Le détail des épaisseurs de couches du réseau RZ se fait par les techniques connues (résolution de l'équation de SCHRÖDINGER).

Comme cela est représenté sur la figure 2b, le premier puits quantique r1 du réseau RZ contient un niveau d'énergie er1 inférieur mais proche du niveau e1.2. Le deuxième puits quantique r2 contient un niveau d'énergie er2 inférieur mais proche du niveau d'énergie er2 et ainsi de suite jusqu'au dernier puits quantique rn qui contient un niveau d'énergie ern légèrement supérieur au niveau e2.1. Ce fonctionnement est réalisé sous champ électrique. Tous les puits du réseau R2 sont fortement couplés, ce qui fait que les fonctions d'ondes des électrons sont relativement délocalisées sur plusieurs puits.

On voit donc que lors de l'émission d'un photon par le laser L1, l'électron n'est pas perdu mais récupéré et injecté dans le laser L2 pour réémettre à nouveau. Dans ces conditions, contrairement à un laser à semiconducteur classique, il ne se produit pas de compétition entre les différentes longueurs d'ondes. Les électrons ne sont pas injectés et consommés dans un seul puits mais traversent tous les puits quantiques, donnant lieu successivement à l'émission des différentes longueurs d'onde correspondantes.

Selon l'exemple des figures 2a et 2b, le nombre de longueurs d'onde pouvant être émises est égal à 2, les lasers L1 et L2 émettant des longueurs d'ondes différentes.

On peut prévoir un plus grand nombre de lasers émettant à des longueurs d'ondes différentes.

Il n'y a pas de limite supérieure au nombre de longueurs d'onde, si ce n'est la limite technologique du nombre de puits quantiques qu'il est possible de déposer sur un substrat. Il n'y a pas non plus de limites spectrales aux longueurs d'onde qu'un tel laser peut émettre simultanément, si ce n'est les limites de ce que l'état de l'art permet de réaliser avec des transitions intersousbandes (pour l'instant entre 1.5 µm et 20 µm).

On peut mettre une ou plusieurs structures pour chaque longueur d'onde : dans le cas d'un laser bicolore par exemple, on a intérêt à mettre beaucoup de puits émettant sur chacune des deux longueurs d'ondes (par exemple 30 sur chaque longueur d'onde), ce qui augmente le gain de chacune des deux longueurs d'onde.

Dans le cas où on veut un grand nombre de longueurs d'onde simultanément, on mettra un nombre plus faible de puits sur chaque longueur d'onde. On obtiendra à partir d'un grand nombre de longueurs d'ondes cumulées une source laser « blanche », c'est-à-dire spectralement très étendu. Une telle source est très intéressante car elle présente une grande étendue spectrale et en même temps les caractéristiques de cohérence spatiale d'un laser, avec notamment une très forte brillance.

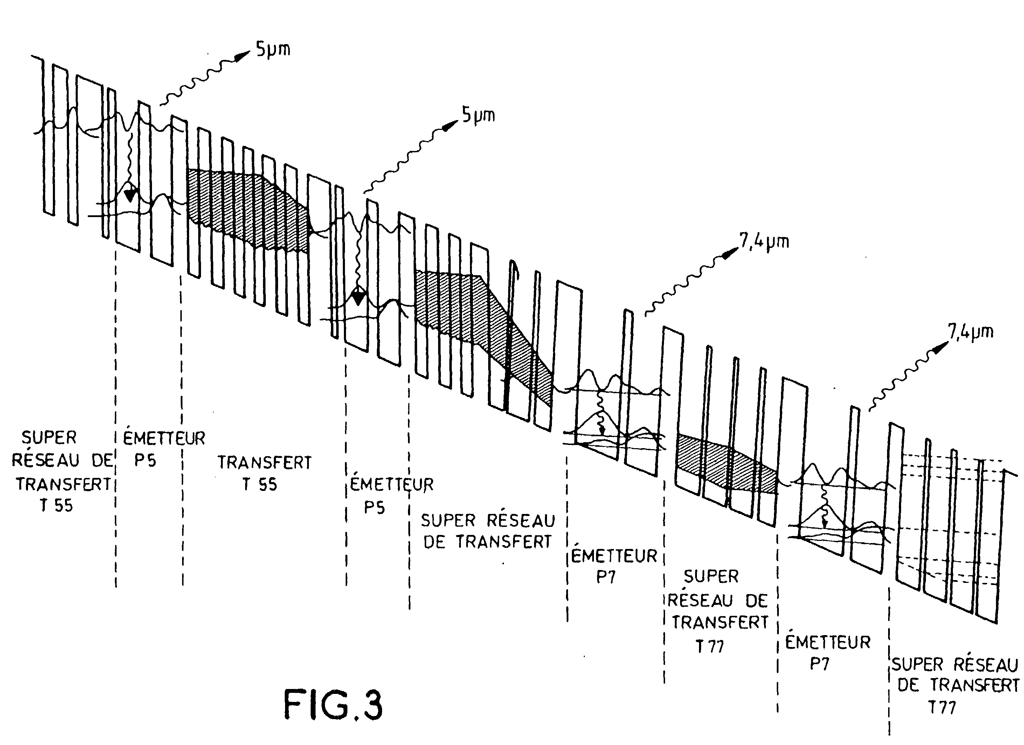

En se reportant à la figure 3, on va maintenant décrire un exemple de réalisation détaillé d'un laser bicolore selon l'invention. Par exemple, les longueurs d'ondes d'émission de ce laser bicolore sont de 5 µm et 7.4 µm.

La structure est composée schématiquement d'un guide d'onde classique dans lequel la lumière est guidée aussi bien à 5 µm qu'à 7.4 µm. Ce guide d'onde peut être obtenu en déposant des couches (non représentées) d'indice de réfraction plus faible en dessous et en dessus du corps du guide, par des techniques classiques de dépôt d'hétérostructures semiconductrices, telles que l'épitaxie par jets moléculaires. Le corps de ce guide d'onde contient la région active, qui contient les puits quantiques émettant les radiations lasers.

Dans la structure de la figure 3, on trouve des émetteurs lasers P5 émettant à 5 µm et des émetteurs lasers P7 émettant à 7.4 µm.

Les différents émetteurs lasers sont donc associés en série à l'aide de réseaux de couplage à puits quantiques.

Le type d'émetteur P5 émettant à 5 µm est par exemple, tel que décrit dans la référence [4], fait d'une succession de couches semiconductrices Al_{0.48}In_{0.52}As/Ga_{0.47}In_{0.53}As, dont les épaisseurs sont calculées de façon à ce que l'écart entre les niveaux impliqués dans la transition intersousbande donne une longueur d'onde égale à 5 µm. Le deuxième type d'émetteur P7 émettant à 7.4µm est de manière analogue à la structure décrite dans la référence [5]. Entre deux émetteurs successifs i et j, le transport est réalisé dans un réseau. Ce réseau est en quelque sorte un raccord assurant le transport entre les deux émetteurs successifs. Il doit avoir les deux propriétés suivantes : une collection efficace des porteurs sur le niveau « bas » d'un émetteur i afin de le vider très rapidement pour obtenir l'inversion de population, et aussi une injection efficace sur le niveau « haut » de l'émetteur suivant j. Dans notre exemple, quatre types de réseau sont réalisés selon le type d'émetteur laser (P5 ou P7) présent de part et d'autre du réseau. Ils sont notés T55, T57, T75 ou T77. Tmn désigne le réseau séparant un émetteur de type Pm et un émetteur de type Pn. Les réseaux Tmn diffèrent par les différentes épaisseurs des couches qui les composent, de manière à établir le raccord entre les niveaux d'énergie des émetteurs i et j, de type m et n, respectivement. Les deux types d'émetteurs P5 et P7 peuvent être réunis de différentes manières : on peut placer tous les émetteurs à 5 µm au début de la structure puis les émetteurs à 7.4 µm à la fin. On obtient au total une structure du type P5/T55/P5/T55/P5/T57/P7/T77/P7/T77. Une solution consiste à placer les émetteurs à 5 pm au milieu de la structure pour optimiser les recouvrements des deux émissions avec les modes fondamentaux du guide d'onde optique. On obtient alors une structure P7/T77/P7 ... T77/P7/T75/P5/T55/P5 ... P5/T57/P7/T77/P7 ... T77/P7. Une autre solution consiste à mélanger les deux types d'émetteurs en les changeant à chaque fois : ... P7/T 75/P5/T57/P7/T75 ...

T55 et T77 organisent le transport entre couches émettrices identiques. Il sont donc tout à fait analogues aux réseaux de transfert utilisés pour les lasers LCQ simples, à une seule longueur d'onde ([4], [5]). Par contre, T57 et T75 sont originaux car ils permettent d'associer des émetteurs à des longueurs d'ondes différentes.

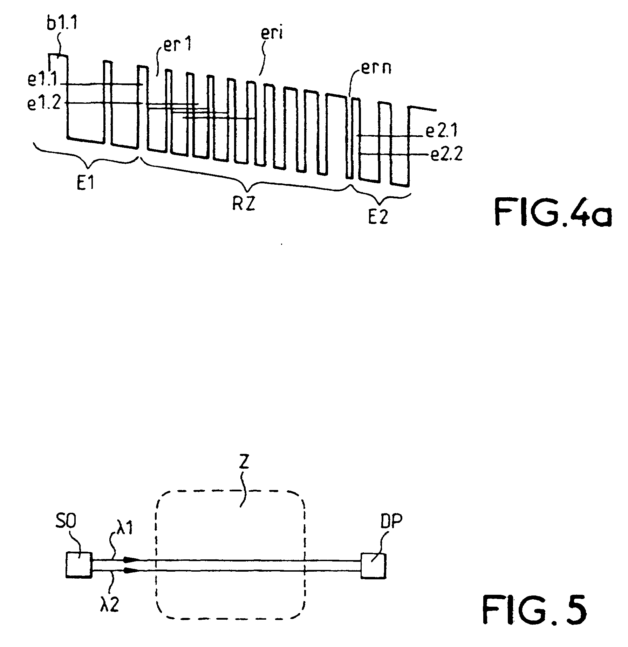

La figure 4a représente un exemple de réalisation d'un réseau dans lequel le niveau d'énergie er1 du premier puits quantique est proche du niveau d'énergie e1.2. Les écarts entre niveaux d'énergie voisins du réseau RZ sont également proches mais peuvent augmenter en allant du puits er1 vers un puits intermédiaire eri, puis diminuer en allant du puits intermédiaire eri vers le dernier puits du réseau ern.

On va maintenant fournir des exemples de réalisation détaillés dans lesquels les couches barrières sont en matériau Al_{0.48}In_{0.52}As et les couches de puits quantiques sont en Ga_{0.47}In_{0.53}As.

### 1er exemple

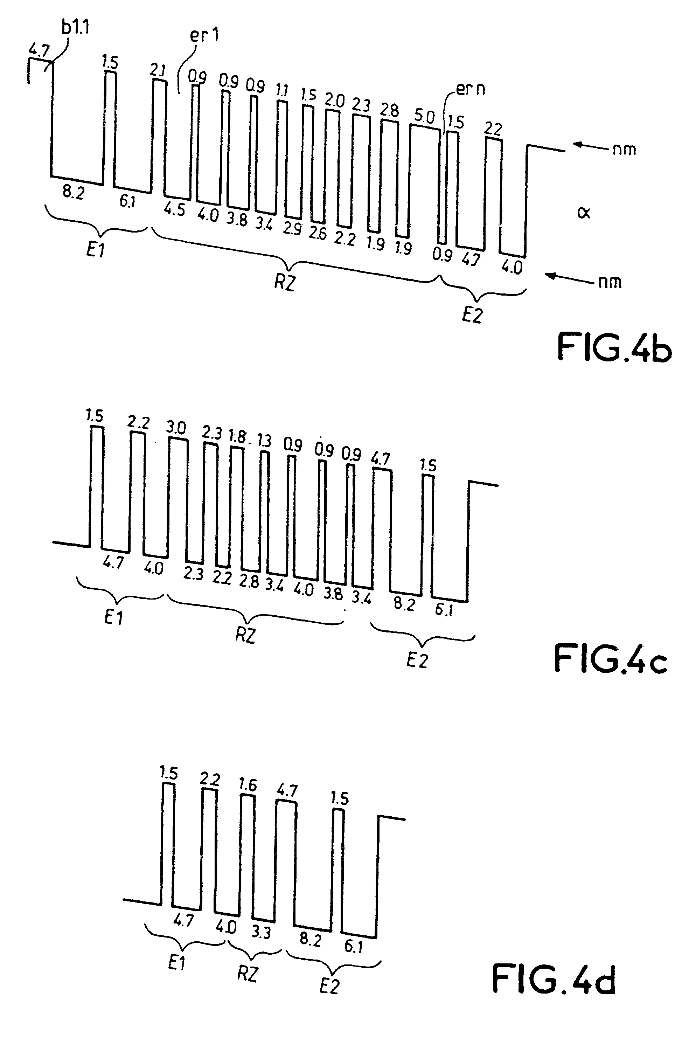

Sur la figure 4b, on a indiqué les épaisseurs (en nanomètres) des couches barrières à la partie supérieure de la bande de conduction de la structure et les épaisseurs (en nanomètres) des couches de puits à la partie inférieure.

L'émetteur E1 émet à 7.4 µm et comporte une couche barrière de 4,7 nm et deux couches de puits de 8,2 nm et 6.1 nm séparées par une fine couche barrière de 1,5 nm.

L'émetteur E2 émet à 5 µm et comporte une couche barrière de 1,5 nm et deux couches de puits de 4,7 nm et 4,0 nm séparées par une fine couche barrière de 2.2 nm.

Des moyens d'application d'un champ électrique non représentés sont connectés de part et d'autre de la structure et appliquant à celle-ci un champ électrique orienté de l'émetteur E1 vers l'émetteur E2.

Le réseau de transfert est constitué d'un empilement de couches barrières et de couches de puits. Les épaisseurs des couches barrières augmentent de l'émetteur E1 vers l'émetteur E2 entre 0,9 nm et 5 nm. Les épaisseurs des couches de puits quantiques diminuent de 4,5 nm à 1,9 nm. Un tel réseau correspond au réseau T75 de la description qui précède.

### 2ème exemple

Le deuxième exemple représenté en figure 4c a pour but de décrire un réseau T57 de la description précédente.

L'émetteur E1 émet à 5 µm. Il comporte une couche barrière de 1,5 nm et deux couches de puits de 4,7 nm et 4,0 nm séparées par une fine couche barrière de 2.2 nm.

L'émetteur E2 émet à 7,4 µm. Il comporte une couche barrière de 4,7 nm et deux couches de puits de 8,2 nm et 6,1 nm séparées par une fine couche barrière de 1,5 nm.

Des moyens d'application d'un champ électrique non représentés sont connectés de part et d'autre de la structure et appliquant à celle-ci un champ électrique orienté de l'émetteur E1 vers l'émetteur E2.

Le réseau de transfert RZ comporte une succession de puits dont les épaisseurs de couches barrières diminuent de 3 nm à 0,9 nm en allant de l'émetteur E1 à l'émetteur E2 tandis que les épaisseurs de couches de puits augmentent de 2,3 nm à 3,4 nm.

### 3ème exemple

La figure 4d représente un émetteur E1 émettant à 5 µm couplé à un émetteur E2 à 7.4 µm. Le réseau de transfert RZ comporte une couche de puits de 3,3 nm encadrée par deux couches barrières de 1,6 nm et 4,7 nm.

Une source multicolore selon l'invention peut trouver des applications pour remplacer un corps noir dans toutes les applications spectroscopiques. Le corps noir ayant une bonne étendue spectrale mais une très mauvaise brillance, inférieure de plusieurs ordres de grandeurs à celle d'un laser. On peut par exemple munir un interféromètre à transformée de Fourier muni d'un laser infrarouge « blanc », présentant un rapport signal bruit bien meilleur, et capable de réaliser la spectroscopie d'objets extrêmement petits (quelques microns) ce que ne permettent absolument pas les interféromètres actuels.

Dans certains cas bien précis, il est possible d'assurer le transfert des électrons d'un premier laser émettant à une première longueur d'onde vers un deuxième laser émettant à une deuxième longueur d'onde en dimensionnant de façon adaptée l'épaisseur de la couche barrière qui les sépare. C'est le cas, par exemple, de la structure suivante :

Le premier laser comporte deux couches de puits d'épaisseurs 4,7 µm et 4,0 µm séparés par une barrière de 2,2 µm, l'ensemble étant enserré entre deux couches barrières de 1,5 µm et 4,7 µm. Ce laser émet à une longueur d'onde de 5 µm.

Le deuxième laser comporte deux couches de puits de 8,2 µm et 6,1 µm séparées par une couche barrière de 1,5 µm. L'ensemble est enserré entre la couche barrière d'épaisseur 4,5 µm du premier laser et une couche barrière d'épaisseur 6,1 µm. Ce deuxième laser émet à une longueur d'onde de 7,4 µm.

L'invention est applicable à un système d'analyse tel que représenté en figure 5.

Le système d'analyse possède une source optique S0, une zone d'éclairement Z dans laquelle sera placé le milieu à observer et un dispositif de photodétection DP recevant la lumière de la source S0 après traversée de la zone Z.

Selon l'invention, la source S0 émet deux longueurs d'ondes λ₁, λ₂. L'une des longueurs d'ondes, λ₁ par exemple, est telle que le milieu à observer est transparent à cette longueur d'onde λ₁. Le dispositif de photodétection est muni de moyens pour mesurer séparément l'intensité lumineuse correspondant à chaque longueur d'onde. De cette façon, le milieu à observer étant transparent à la longueur d'onde λ₁, la lumière à λ₁ servira de niveau de référence pour mesurer l'intensité lumineuse à λ₂ et donc l'absorption de la lumière à λ₂ par le milieu.

Le dispositif de photodétection peut être par exemple muni de deux photodétecteurs commutables sensibles l'un à λ₁ et l'autre à λ₂. Ou bien il n'est prévu qu'un seul photodétecteur large bande et on prévoit des filtres commutables à λ₁ et λ₂ entre la zone Z et le dispositif de photodétection.

### Références :

(1) N.W. Carlson, Monolithic Diode-Laser Arrays, Springer Verlag (1994).
(2) F. Capasso, A.Y. Cho, J. Faist, A.L. Hutchinson, S. Luryi, C. Sirtori, D.L. Sivco, Unipolar Semiconductor Laser, european patent application (application number 95302112.8).
(3) J. Faist, F. Capasso, D.L. Sivco, C. Sirtori, A.L. Hutchinson, A.Y. Cho, Quantum cascade laser, Science, vol 264, p 553.
(4) J. Faist, F. Capasso, C. Sirtori, D.L. Sivco, J.N. Baillargeon, A.L. Hutchinson, S.N.G. Chu and A.Y. Cho, High power mid-infrared (λ ≈ 5 µm) quantum cascade operating above room temperature, Appl. Phys. Lett., vol 68, p 3680.
(5) C. Sirtori, J. Faist, F. Capasso, DL. Suro, A.L. Hutchinson, S.N. George Chu, A.Y, Cho « Continuous wave operation of midinfrared (7.4-8,6 µm) Quantum Cascade Lasers up to 110 K temperature » Appl. Phys. Lett. 68, p 1745.

## Revendications

1. Laser unipolaire à puits quantiques comprenant au moins deux empilements de couches de matériaux semiconducteurs, chaque empilement constituant un laser à puits quantique (L1, L2) à fonctionnement intra-bande et émettant une longueur d'onde déterminée, les deux empilements de couches (L1, L2) étant séparés par un empilement de couches de matériaux semiconducteurs constituant un réseau de transfert (RZ) à puits quantiques permettant sous champ électrique un transfert d'électrons entre le niveau bas de la bande (e1.2) de conduction ou de valence d'un puits quantique d'un premier laser (L1) vers le niveau haut de la bande (e2.1) respectivement de conduction ou de valence, du puits quantique d'un deuxième laser (L2) **caractérisé en ce que** le laser unipolaire à puits quantiques émet plusieurs longueurs d'ondes.

2. Laser selon la revendication 1, **caractérisé en ce que** :
- un premier puits quantique (r1) du réseau accolé au premier laser (L1) possède un niveau d'énergie (er1) legèrement inférieur au niveau d'énergie le plus bas (e1.2) de ce premier laser (L1);
- les puits quantiques du réseau possèdent des niveaux d'énergie dont les valeurs diminuent du premier puits (r1) vers un deuxième puits quantique (rn) accolé au deuxième laser (L2).

3. Laser selon la revendication 2, **caractérisé en ce que** le deuxième puits quantique (rn) possède un niveau d'énergie (ern) légèrement supérieur au niveau d'énergie le plus haut (e2.1) du deuxième laser (L2).

4. Laser selon la revendication 2, **caractérisé en ce que** les différences des niveaux d'énergie des puits du réseau (RZ) sont tels qu'entre le premier puits quantique et un puits intermédiaire ces différences augmentent tandis qu'entre ledit puits intermédiaire et le deuxième puits, ces différences diminuent.

5. Laser selon la revendication 4, **caractérisé en ce qu'**il comporte une succession de lasers à puits quantiques émettant chacun une longueur d'onde particulière, deux lasers voisins étant reliés par un réseau de transfert (RZ).

6. Laser selon la revendication 5, **caractérisé en ce qu'**au moins un premier groupe de lasers émet une première longueur d'onde particulière, et un deuxième groupe de lasers émet une deuxième longueur d'onde particulière, les lasers de chaque groupe étant couplés entre eux par des réseaux d'un premier type et les deux groupes de lasers étant couplés entre eux par un réseau d'un deuxième type.

7. Laser selon la revendication 2, **caractérisé en ce que** le puits quantique du premier laser (L1) émet à une longueur d'onde supérieure à celle du deuxième laser (L2) et **en ce que** le réseau de transfert (RZ) comporte un empilement de puits quantiques dont les épaisseurs des couches de barrières de puits augmentent et les épaisseurs des couches de puits diminuent en allant du premier laser (L1) vers le deuxième laser (L2).

8. Laser selon la revendication 2, **caractérisé en ce que** le puits quantique du premier laser (L1) émet à une longueur d'onde inférieure à celle du deuxième laser (L2) et **en ce que** le réseau de transfert (RZ) comporte un empilement de puits quantiques dont les épaisseurs des couches de barrières diminuent et les épaisseurs des couches de puits augmentent en allant du premier laser (L1) vers le deuxième laser (L2).

9. Système d'analyse comprenant une source lumineuse (SO) transmettant un faisceau lumineux à une zone d'observation (Z) et un dispositif de photodétection (DP) recevant ce faisceau lumineux après traversée de la zone d'observation (Z), **caractérisé en ce que** la source lumineuse (SO) comporte un laser selon l'une des revendications précédentes émettant deux longueurs d'ondes (λ₁, λ₂) et **en ce que** le dispositif de photodétection (DP) comporte des moyens pour mesurer l'intensité lumineuse séparément aux deux longueurs d'ondes (λ₁, λ₂) émises par le laser.

## Patentansprüche

1. Unipolarer Laser mit Quantenschächten, der mindestens zwei Stapelungen von Schichten aus Halbleiterwerkstoffen umfasst, wobei jeder Stapel einen Laser mit Quantenschacht (L1, L2) mit Intrabandbetrieb bildet und eine bestimmte Wellenlänge sendet, wobei die zwei Stapelungen von Schichten (L1, L2) durch eine Stapelung von Schichten aus Halbleiterwerkstoffen getrennt sind, die ein Transfernetz (RZ) mit Quantenschächten bilden, das unter einem elektrischen Feld einen Elektronentransfer zwischen dem unteren Niveau des Bands (e1.2) der Leitung oder Valenz eines Quantenschachts eines ersten Lasers (L1) zum oberen Niveau des Bands (e2.1) jeweils der Leitung oder Valenz des Quantenschachts eines zweiten Lasers (L2) gestattet, **dadurch gekennzeichnet, dass** der unipolare Laser mit Quantenschächten mehrere Wellenlängen sendet.

2. Laser nach Anspruch 1, **dadurch gekennzeichnet, dass**:
- ein erster Quantenschacht (r1) des Netzes, der an den ersten Laser (L1) anliegt, ein Energieniveau (erl) besitzt, das leicht niedriger ist als das niedrigste Energieniveau (e1.2) dieses ersten Lasers (L1);
- die Quantenschächte des Netzes Energieniveaus besitzen, deren Werte vom ersten Quantenschacht (r1) zu einem zweiten Quantenschacht (rn), der an den zweiten Laser (L2) anliegt, abnehmen.

3. Laser nach Anspruch 2, **dadurch gekennzeichnet, dass** der zweite Quantenschacht (rn) ein Energieniveau (ern) besitzt, das leicht höher ist als das höchste Energieniveau (e2.1) des zweiten Lasers (L2).

4. Laser nach Anspruch 2, **dadurch gekennzeichnet, dass** die Unterschiede der Energieniveaus der Quantenschächte des Netzes (R2) dergestalt sind, dass diese Unterschiede zwischen dem ersten Quantenschacht und einem Zwischenquantenschacht zunehmen, während diese Unterschiede zwischen dem Zwischenquantenschacht und dem zweiten Quantenschacht abnehmen.

5. Laser nach Anspruch 4, **dadurch gekennzeichnet, dass** er eine Abfolge von Lasern mit Quantenschächten umfasst, von welchen jeder eine bestimmte Wellenlänge sendet, wobei zwei benachbarte Laser durch ein Transfernetz (RZ) verbunden sind.

6. Laser nach Anspruch 5, **dadurch gekennzeichnet, dass** mindestens eine erste Gruppe von Lasern eine erste spezielle Wellenlänge sendet, und dass eine zweite Gruppe von Lasern eine zweite bestimmte Wellenlänge sendet, wobei die Laser jeder Gruppe durch Netze eines ersten Typs untereinander gekoppelt sind, und die zwei Lasergruppen untereinander durch ein Netz eines zweiten Typs gekoppelt sind.

7. Laser nach Anspruch 2, **dadurch gekennzeichnet, dass** der Quantenschacht des ersten Lasers (L1) mit einer Wellenlänge sendet, die größer ist als die des zweiten Lasers (L2), und dadurch, dass das Transfernetz (RZ) eine Stapelung von Quantenschächten umfasst, deren Stärken der Schachtbarrierenschichten zunehmen und deren Stärken der Schachtschichten vom ersten Laser (L1) zum zweiten Laser (L2) abnehmen.

8. Laser nach Anspruch 2, **dadurch gekennzeichnet, dass** der Quantenschacht des ersten Lasers (L1) mit einer Wellenlänge sendet, die kleiner ist als die des zweiten Lasers (L2), und dadurch, dass das Transfernetz (RZ) eine Stapelung von Quantenschächten umfasst, deren Stärken der Barrierenschichten abnehmen und deren Stärken der Schachtschichten vom ersten Laser (L1) zum zweiten Laser (L2) zunehmen.

9. Analysesystem, das eine Lichtquelle (SO) enthält, die einen Lichtstrahl auf eine Beobachtungszone (Z) überträgt, und eine Lichtsensorvorrichtung (DP), der diesen Lichtstrahl nach dem Durchqueren der Beobachtungszone (Z) empfängt, **dadurch gekennzeichnet, dass** die Lichtquelle (SO) einen Laser nach einem der vorhergehenden Ansprüche umfasst, der zwei Wellenlängen (λ₁, λ₂) sendet, und dadurch, dass die Lichtsensorvorrichtung (DP) Mittel umfasst, um die Lichtstärke an den zwei Wellenlängen (λ₁, λ₂), die von dem Laser gesendet werden, getrennt zu messen.

## Claims

1. Unipolar quantum-well laser comprising at least two multilayer stacks of semiconductor materials, each stack constituting a quantum-well laser (L1, L2) with intraband operation and emitting a defined wavelength, the two multilayer stacks (L1, L2) being separated by a multilayer stack of semiconductor materials constituting a quantum-well transfer grating (RZ) allowing, under an electric field, electron transfer between the low level (e1.2) of the conduction or valence band of a quantum well of a first laser (L1) to the high level (e2.1) respectively of the conduction or valence band of the quantum well of a second laser (L2), **characterized in that** the unipolar quantum-well laser emits several wavelengths.

2. Laser according to Claim 1, **characterized in that**:
- a first quantum well (r1) of the grating affixed to the first laser (L1) possesses an energy level (er1) slightly below the lowest energy level (e1.2) of this first laser (L1); and
- the quantum wells of the grating possess energy levels whose values decrease from the first well (r1) to a second quantum well (rn) affixed to the second laser (L2).

3. Laser according to Claim 2, **characterized in that** the second quantum well (rn) possesses an energy level (ern) slightly above the highest energy level (e2.1) of the second laser (L2).

4. Laser according to Claim 2, **characterized in that** the differences in the energy levels of the wells of the grating (RZ) are such that, between the first quantum well and an intermediate well, these differences increase whereas, between the said intermediate well and the second well, these differences decrease.

5. Laser according to Claim 4, **characterized in that** it comprises a succession of quantum-well lasers each emitting a particular wavelength, two adjacent lasers being linked by a transfer grating (RZ).

6. Laser according to Claim 5, **characterized in that** at least a first group of lasers emits a first particular wavelength and a second group of laser emits a second particular wavelength, the lasers of each group being mutually coupled by gratings of a first type and the two groups of lasers being mutually coupled by a grating of a second type.

7. Laser according to Claim 2, **characterized in that** the quantum well of the first laser (L1) emits at a wavelength longer than that of the second laser (L2) and **in that** the transfer grating (RZ) comprises a quantum-well stack, the thicknesses of the well barrier layers of which increase and the thicknesses of the well layers of which decrease on going from the first laser (L1) to the second laser (L2).

8. Laser according to Claim 2, **characterized in that** the quantum well of the first laser (L1) emits at a wavelength shorter than that of the second laser (L2) and **in that** the transfer grating (RZ) comprises a quantum-well stack, the thicknesses of the barrier layers of which decrease and the thicknesses of the well layers of which increase on going from the first laser (L1) to the second laser (L2).

9. Analysis system comprising a light source (SO) that transmits a light beam to an observation region (Z) and a photodetection device (DP) that receives this light beam after it has passed through the observation region (Z), **characterized in that** the light source (SO) comprises a laser according to one of the preceding claims which emits two wavelengths (λ₁, λ₂), and **in that** the photodetection device (DP) comprises means for measuring the light intensity separately at the two wavelengths (λ₁, λ₂) that are emitted by the laser.
